# EUROPEAN PATENT APPLICATION

(11) **EP 3 832 743 A1**
(43) Date of publication of application: **09.06.2021**
(21) Application number: 19214053.1
(22) Date of filing: 06.12.2019
(51) Int. Cl.: H01L 43/08, H01L 43/12

(54) **INTEGRATING AN MRAM DEVICE WITH A COPPER-BASED INTERCONNECT STRUCTURE**

(71) Applicant: Imec VZW, 3001 Leuven (BE)
(72) Inventor: YASIN, Farrukh, 3001 Leuven (BE); CROTTI, Davide Francesco, 3001 Leuven (BE); KAR, Gouri Sankar, 3001 Leuven (BE)
(74) Representative: Roth, Sebastian

(57) **Abstract**

The present invention relates to Magnetoresistive Random Access Memory (MRAM) devices. The invention provides a method for integrating an MRAM device with a copper-based interconnect structure. Further, the invention provides an integrated device, which comprises an MRAM device integrated with a copper-based interconnect structure. The method comprises forming a recess in a top part of a copper plug of the interconnect structure, forming an embedded layer in the recess, and fabricating an MRAM stack on the embedded layer to form the MRAM device, wherein the copper plug forms a bottom electrode of the MRAM device.

## Description

### TECHNICAL FIELD

Generally, the present invention relates to memory devices, in particular to Magnetoresistive Random Access Memory (MRAM) devices. The invention provides a method for integrating an MRAM device with a copper-based interconnect structure. Further, the invention provides an integrated device, which comprises an MRAM device integrated with a copper-based interconnect structure.

### BACKGROUND OF THE INVENTION

A conventional scheme of integrating an MRAM device with a copper-based interconnect structure, in the back end of line (BEOL), requires a bottom electrode (BE) made of tungsten (W) or another metal, to connect the MRAM device to the interconnect structure, e.g., to standard Cu lines/plugs of the interconnect structure. In particular, in this conventional integration scheme, a smooth surface of the bottom electrode (BE) is created.

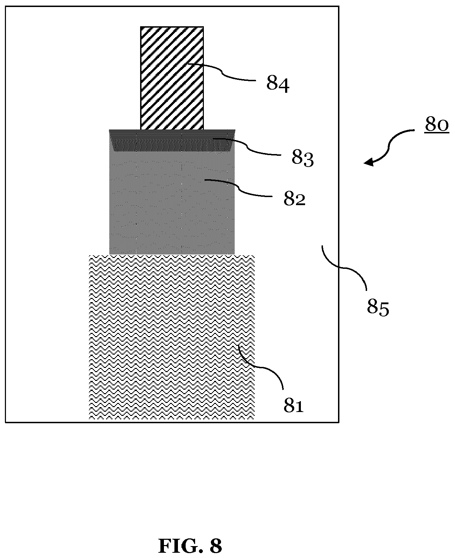

FIG. 8 illustrates the conventional integration scheme. In particular, FIG. 8 shows a final integrated device 80, which comprises a copper plug 81 of the copper-based interconnect structure, and an MRAM stack 84 for an MRAM device. To integrate the MRAM stack 84 with the copper plug 81, the BE 82 (typically made of W) is provided on top of the copper plug 81. Further an embedded layer 83 (typically made of TaN) is provided at the top surface of the BE 82. The BE 82 is, to this end, recessed, subsequently filled with the embedded layer material, and finally chemical mechanical polishing (CMP) is applied to obtain a smooth surface of the embedded layer 83. Further, the MRAM stack 84 is then provided on the embedded layer 83.

Disadvantageously, this conventional integration scheme requires critical lithography operations (high cost), and at minimum ten extra process operations to create the BE 82. Further, as it can be derived from FIG. 8, the BE 82 adds significantly to the thickness of the MRAM device (it acts as the bottom electrode of the MRAM device connected via the embedded layer 83 to the MRAM stack 84). This is highly undesirable, in particular, for advanced technology nodes where ix integration schemes do not have the vertical space for using this kind of BE 82.

### SUMMARY OF THE INVENTION

In view of the above-mentioned disadvantages, embodiments of the present invention aim to provide an improved scheme of integrating an MRAM device with a copper-based interconnect structure. An objective is in particular to simplify a method for realizing the integration. Further, a goal is to reduce a thickness of the integrated device, and specifically of the MRAM device. Thus, one desire is to find an alternative to the BE required in the conventional integration scheme. The method should also enable 1x integration schemes implemented with aggressive vertical pitches/dimensions.

The objective is achieved by the embodiments of the invention provided in the enclosed independent claims. Advantageous implementations of these embodiments are defined in the dependent claims.

In particular, the embodiments of the invention base on creating a smooth surface directly on a copper (Cu) plug of the copper-based interconnect structure. This means that the MRAM stack can be arranged directly on top of the copper plug.

A first aspect of the invention provides a method for integrating a MRAM device with a copper-based interconnect structure, the method comprising: forming a recess in a top part of a copper plug of the interconnect structure, forming an embedded layer in the recess, and fabricating an MRAM stack on the embedded layer to form the MRAM device, wherein the contact plug forms a bottom electrode of the MRAM device.

The "copper plug" may include multiple copper plugs, one or more copper lines, or one or more copper vias, of the copper-based interconnect structure.

The embedded layer may provide a smooth surface at the top of the copper plug. Thus, the MRAM stack can be provided directly on the copper-based interconnect structure with good contact. Thereby, at least ten processing operations are eliminated, and also one or more additional, cost heavy lithography operations can be eliminated, which would have been needed to create, e.g. the BE 82. This results in a more industry friendly integration scheme.

Furthermore, the BE provided in the conventional integration scheme between the copper-based interconnect structure and the MRAM stack is eliminated, thus making the integrated device much more compact. In particular, the MRAM device, which comprises the MRAM stack and the copper plug functioning as bottom electrode, can be made much thinner than in the conventional integration scheme.

In an implementation of the method, the embedded layer comprises a titanium layer, titanium nitride layer, tantalum layer, tantalum nitride layer, and/or tungsten layer.

These materials allow to create a particular smooth embedded layer surface, and provide a particular good contact between the copper plug and the MRAM stack.

In an implementation of the method, the MRAM stack comprises a Magnetic Tunnel Junction (MTJ) stack, which includes two magnetic layers that sandwich a tunnel barrier, and the MTJ stack is fabricated directly on the embedded layer.

In an implementation of the method, fabricating the MRAM stack on the embedded layer is performed in a single mask flow.

In the conventional integration scheme, fabricating the MRAM stack on the copper-based interconnect structure cannot be done in a single mask flow, since the fabrication of the additional BE requires at least one extra mask and lithography step. Thus, the conventional integration scheme is more complex and costly.

In an implementation, the method further comprises: pre-cleaning the recess, before depositing the embedded layer into the recess.

This leads to a significantly better contact/interface between the copper plug and the embedded layer.

In an implementation of the method, the pre-cleaning and the depositing of the embedded layer are performed in-situ without an air break in between.

This leads to a higher quality embedded layer, which may, for example, be fabricated by deposition.

In an implementation of the method, the pre-cleaning comprises argon sputtering of the recess.

Such a pre-cleaning technique can be easily and efficiently performed in-situ.

In an implementation of the method, the recess is formed by dry etching or wet etching, in particular by cyclic dry or wet etching.

This enables a highly controlled recess process of the top part of the copper plug, thus making the formation of the embedded layer directly on copper very feasible.

In an implementation of the method, the recess has a depth of 20-30 nm into the top part of the copper plug.

These depths allow to create the embedded layer with a very smooth surface, on the one hand, while on the other hand also guaranteeing a good contact between the copper plug and the MRAM stack.

In an implementation, the method further comprises: smoothing the surface of the embedded layer, before fabricating the MRAM stack on the embedded layer.

This allows creating an ultra-smooth embedded layer surface, for an optimum contact to the MRAM stack.

In an implementation, the method further comprises: smoothing the surface of the copper plug, before forming the recess in the top part of the copper plug.

This improves the creation of the recess, and thus improves the quality of the embedded layer.

In an implementation, the method further comprises: fabricating a further copper plug or a copper line on top of the MRAM device.

In an implementation of the method, the further copper plug or the copper line is fabricated based on a Damascene process, in particular a dual Damascene process.

The above implementation forms enable to insert the MRAM device in between two copper-based interconnect structures, which are arranged one above the other, for instance, on different layers of a device or chip.

A second aspect of the invention provides an integrated device fabricated by using the method according to the first aspect or any implementation form thereof.

The integrated device can be fabricated using a less complex fabrication method, and thus may enjoy higher yield. Further, the integrated device can be designed more compact than with the conventional integration scheme, in particular because the MRAM device is thinner (less high).

A third aspect of the invention provides an integrated device including a MRAM device integrated with a copper-based interconnect structure, the integrated device comprising: a copper plug of the interconnect structure, an embedded layer formed in a recess in a top part of the copper plug, and an MRAM stack arranged on the embedded layer, wherein the MRAM device is formed by the MRAM stack and the copper plug, the copper plug forming a bottom electrode of the MRAM device.

The integrated device according to the third aspect may have, in implementation forms of the integrated device, further features that correspond to the features fabricated in the implementation forms of the method of the first aspect.

The integrated device can be designed more compact than an integrated device resulting from the conventional integration scheme (see e.g. FIG. 8), in particular since the copper plug forms itself the bottom electrode of the MRAM device, and not the BE 82 as in the conventional integration scheme.

### BRIEF DESCRIPTION OF THE DRAWINGS

The above described aspects and implementations are explained in the following description of embodiments with respect to the enclosed drawings:
- FIG. 1: shows a method according to a general embodiment of the invention.
- FIG. 2: shows steps of a method according to a specific embodiment of the invention.
- FIG. 3: shows further steps of the method according to the specific embodiment of the invention.
- FIG. 4: shows further steps of the method according to the specific embodiment of the invention.
- FIG. 5: shows further steps of the method according to the specific embodiment of the invention.
- FIG. 6: shows further steps of the method according to the specific embodiment of the invention.
- FIG. 7: shows further steps of the method according to the specific embodiment of the invention.
- FIG. 8: shows an integrated device according to a conventional integration scheme.

### DETAILED DESCRIPTION OF EMBODIMENTS OF THE INVENTION

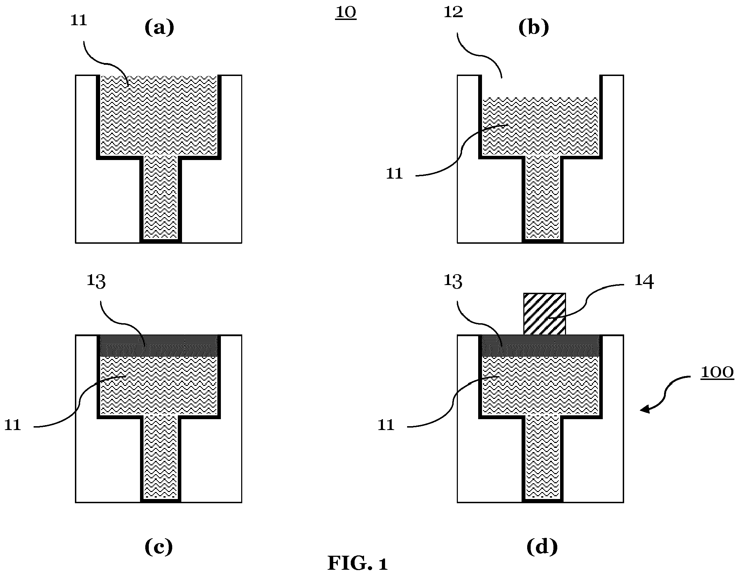

FIG. 1 shows a method 10 according to a general embodiment of the invention. In particular, the method 10 is suitable for integrating an MRAM device with a copper-based interconnect structure. In particular, FIG. 1 shows how an MRAM stack 14 (of the MRAM device) can be integrated with a copper plug 11 (of the copper-based interconnect structure).

FIG. i(a) shows that, initially, a copper plug 11 is provided. The copper plug 11 may include copper one or more plugs, copper vias, copper lines, or other copper elements belonging to the copper-based interconnect structure. The copper plug 11 may have a top surface, onto which further processing is performed in the following.

FIG. i(b) shows a step of forming a recess 12 in the top part (at the top surface) of the copper plug 11. The recess 12 may be formed by controlled etching, particularly cyclic etching, more particularly cyclic wet etching, of the copper material at the top surface of the copper plug 11.

FIG. i(c) shows a step of forming an embedded layer 13 in the recess 12. The embedded layer 13 may be deposited into the recess 12, e.g. by atomic layer deposition (ALD), chemical vapour deposition (CVD), physical vapour deposition (PVD), or similar conventional deposition techniques. The embedded layer 13 may comprises a titanium layer, a titanium nitride layer, a tantalum layer, a tantalum nitride layer, and/or a tungsten layer.

FIG. i(d) shows a step of fabricating the MRAM stack 14 on top of the embedded layer 13, in order to proceed towards forming the MRAM device. The copper plug 11 thereby functions as the bottom electrode of the MRAM device, and is connected to the MRAM stack 14 from below. The MRAM stack 14 may comprises a MTJ stack, which may include two magnetic layers that sandwich a tunnel barrier. The embedded layer 13 may be connected, from below, to the lower magnetic layer (e.g. a magnetic free layer). The tunnel barrier (e.g., comprising MgO) may be provided on this lower magnetic layer (e.g., comprising Co or CoFeB), and the upper magnetic layer (e.g. a magnetic reference layer) may be provided on the tunnel barrier, and a top electrode may be formed on the upper magnetic layer (e.g., comprising Co, or CoFeB).

FIG. i(d) also shows the integrated device 100 that is obtained. The integrated device 100 comprises the copper plug 11 of the interconnect structure, and the embedded layer 13, which is formed in the recess 12 in the top part of the copper plug 11. Further, the integrated device 100 comprises the MRAM stack 14 arranged on the embedded layer 13. The MRAM device includes the MRAM stack 14 and the copper plug 11, wherein the copper plug 11 forms a bottom electrode of the MRAM device.

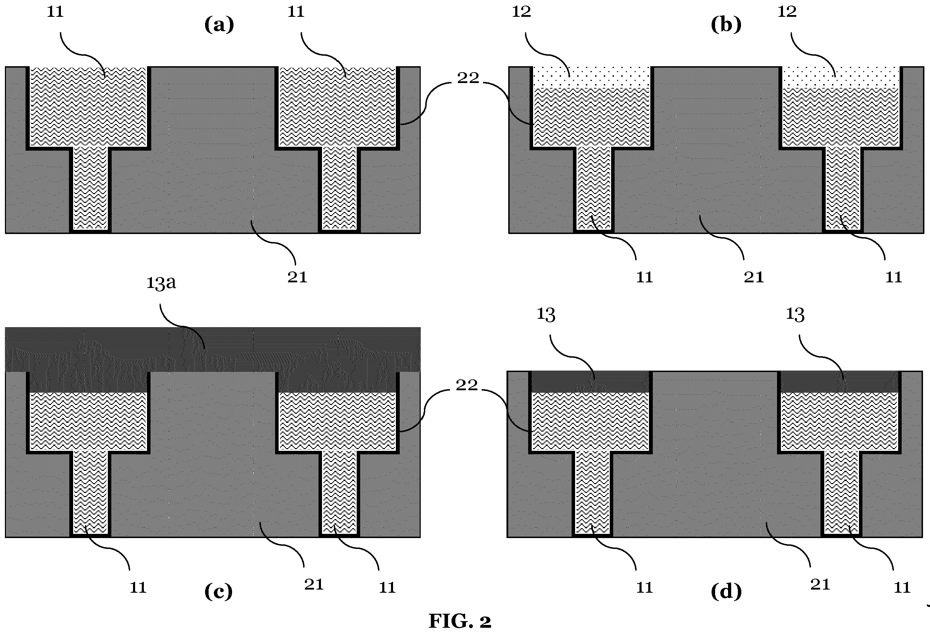

FIGs. 2-7 show the method 10 according to a specific embodiment of the invention, which bases on the general embodiment shown in FIG. 1. The FIGs. 2-7 show, in particular, multiple detailed steps of the method 10 according to this specific embodiment. As shown in the FIGs. 2-7, an MRAM device is integrated into a process flow (comprising method 10) of creating two copper-based interconnect structures, which are arranged one above the other, e.g. on different layers of a device or chip.

FIG. 2(a) shows that, initially, two (or more) copper plugs 11 maybe provided (e.g., each copper plug 11 providing a surface with copper trenches or vias). The copper plugs 11 may each be surrounded by a barrier 22 (e.g., comprising TaN), and may each be embedded into a dielectric material (e.g., comprising an oxide, like SiOx).

FIG. 2(b) shows the formation of a recess 12 in the top part of each copper plug 11. In particular, a controlled copper recess process may be performed. The copper recess process may comprise a cyclic controlled oxidation of the copper (surface), e.g. via a wet oxidizer chemistry. This may be followed by a controlled removal of the oxidized copper layer, e.g. via a wet etch chemistry. The depth of the copper recess 12, which may be about 20-30 nm, has a good reproducibility, due to the oxidation/etch process, which has a highly controlled sub-nanometer per cycle recess control.

FIG. 2(c) shows that, after forming the recesses 12, embedded layer material 13a (e.g., comprising TaN) is deposited into each recess 12 and over the entire surface of the intermediate structure obtained after FIG. 2(b). In particular, the deposition of the embedded layer material 13a may include a pre-clean process of the recesses 12.

FIG. 2(d) shows that CMP is the performed on the embedded layer material 13a, in order to form an embedded layer 13 in the recess 12 of each copper plug 11. In particular, an ultra-smooth surface of each embedded layer 13 may thus be obtained. The CMP may stop on the surface of the dielectric material 21.

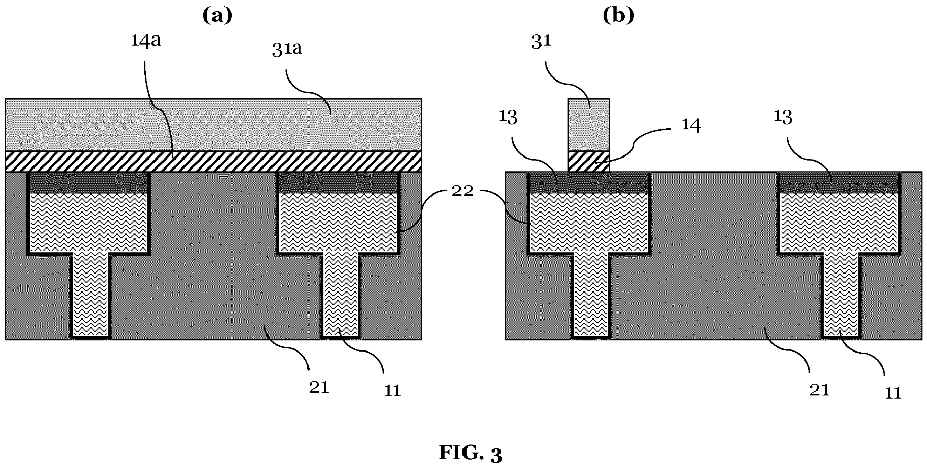

FIG. 3(a) shows that an MRAM stack layer 14a is then formed on the surface of the embedded layers 13 and on the surface of the dielectric material 21 surrounding the copper plugs 11. Further, a hardmask layer material 31a (e.g., comprising TiN) is formed on the memory stack layer 14a.

FIG. 3(b) shows that the hardmask layer material 31a and the MRAM stack layer 14a are then patterned, in order to obtain an MRAM stack 14 on at least one of the copper plugs 11 (here only the left copper plug 11), in particular on top of the embedded layer 13 of that copper plug 11. Further, a hardmask layer 31 is formed on the MRAM stack 14. The hardmask layer (e.g., TiN layer) may function as top electrode of the MRAM device. That means, the MRAM device may be formed by the copper plug 11/embedded layer 13 (functioning as bottom electrode), the MRAM stack (e.g., comprising a MTJ), and the hardmask layer 31 (functioning as top electrode). The pattering may be carried out by using a single lithographic exposure. On the at least one copper plug 11 on which no MRAM stack 14 is formed (here the right copper plug 11) the hardmask layer material 31a and the MRAM stack layer 14a are completely removed, exposing again the surface embedded layer 13. The surface of the dielectric material 21 is also exposed.

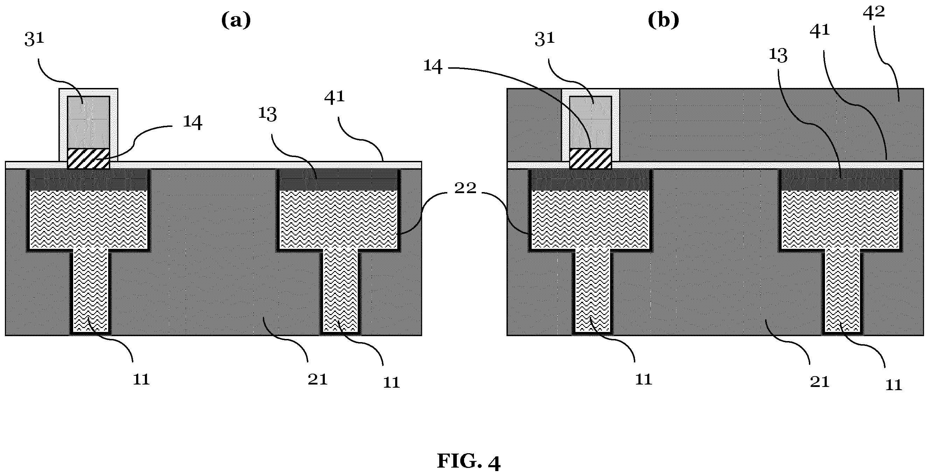

FIG. 4(a) shows that the MRAM device is then encapsulated by an encapsulation layer 41 (e.g., comprising SiN), which is formed on the exposed top surfaces of the MRAM device and the intermediate structure obtained in FIG. 3(b), respectively, and on the side surfaces of the MRAM device.

FIG. 4(b) shows a gap/fill deposition of additional dielectric material 42 (e.g., comprising oxide like SiOx) followed by CMP, so that the entire intermediate structure shown in FIG. 4(b) has a level upper surface. Specifically, a top surface of the additional dielectric material 42 and a top surface of the encapsulated MRAM device are aligned.

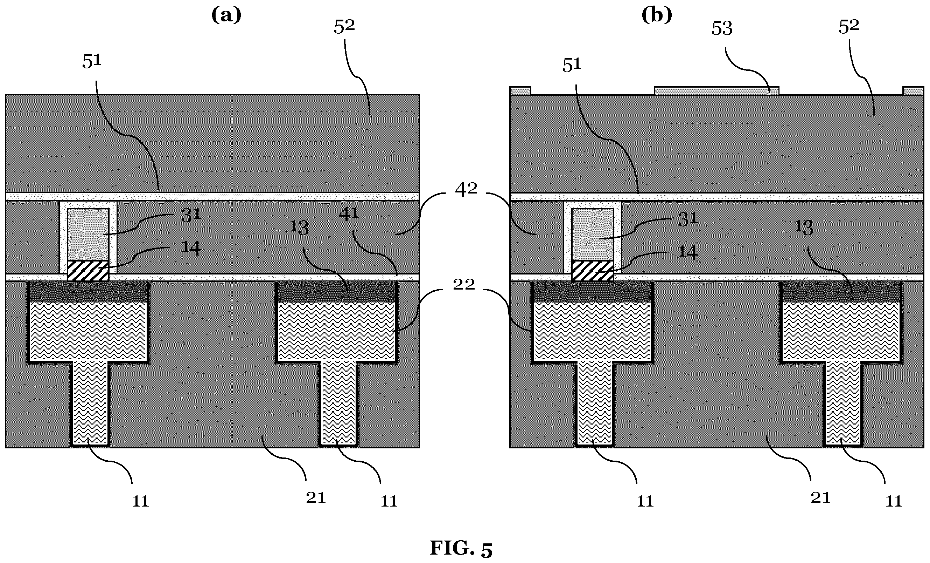

FIG. 5(a) shows that a barrier layer 51 (e.g., comprising SiN) is formed on the top surface of the intermediate structure obtained in FIG. 4(b), and that further dielectric material 52 (e.g., comprising oxide like SiOx) is deposited onto the barrier layer 51. The further dielectric material 52 maybe used for a following dual Damascene process.

FIG. 5(b) shows that a hardmask 53 (e.g., comprising TiN) is formed on the top surface of the further dielectric material 52.

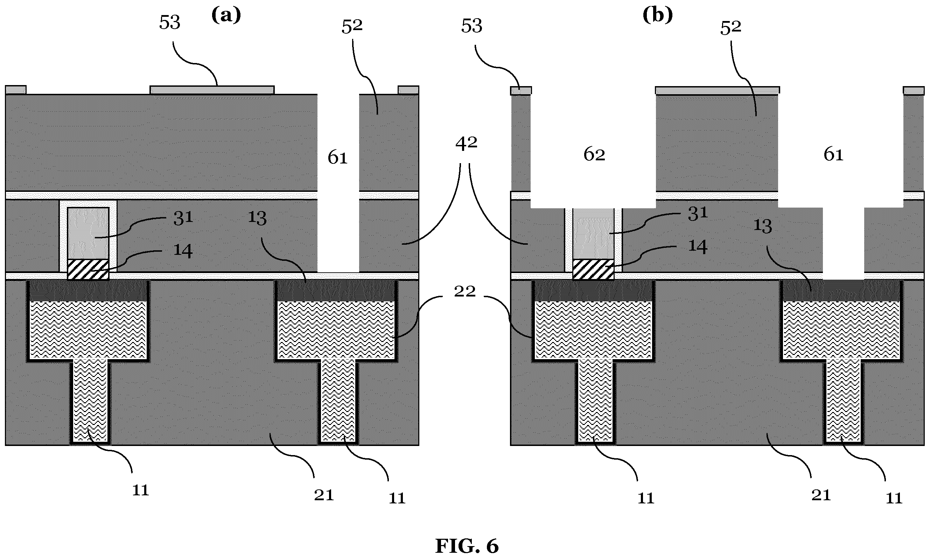

FIG. 6(a) shows that by performing lithography and etching, for implementing a dual damascene process, a first trench 61 is formed over the copper plug 11 not carrying an MRAM device (here the right copper plug 11). The first trench 61 is formed through the further dielectric material 52, the barrier layer 51, and the additional dielectric material 42, and lands on the encapsulation layer 41 provided on the embedded layer 13 of that plug 11.

FIG. 6(b) shows that a second trench 62 may be formed by lithography and etching, for implementing the dual damascene process. The second trench 62 may be formed over the copper plug 11 carrying the MRAM device (here the left copper plug 11). The second trench 62 is formed through the further dielectric material 52 and the barrier layer 51, and lands on the hardmask layer 31 functioning as top electrode of the MRAM device.

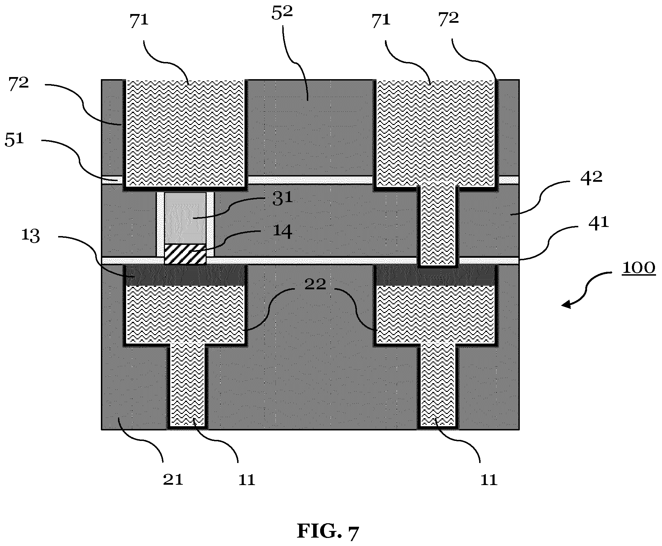

FIG. 7 shows that the sider surfaces and bottom surfaces exposed by/inside the first trench 61 and the second trench 62, respectively, are provided with a barrier 72 (e.g., comprising TaN). Then, the first trench 61 and the second trench 62 are filled with copper material (for forming a further copper plug 71, or a copper line, of an upper copper-based interconnect structure), and CMP may be applied to the copper material for the further copper plug 71, or copper line, to finish the dual Damascene process. The MRAM device is thus embedded between the lower copper-based interconnect structure including the copper plugs 11 and the upper copper-based interconnect structure including the copper plugs 71, or copper lines.

In summary, the embodiments of the invention provide a new integration scheme for an MRAM device and at least one copper-based interconnect structure. The new integrations scheme is less complex (process-wise, i.e. the method 10) and results in a more compact integrate device 100.

## Claims

1. Method (10) for integrating a Magnetoresistive Random Access Memory, MRAM, device with a copper-based interconnect structure, the method (10) comprising:
forming a recess (12) in a top part of a copper plug (11) of the interconnect structure,
forming an embedded layer (13) in the recess (12), and
fabricating an MRAM stack (14) on the embedded layer (13) to form the MRAM device, wherein the copper plug (11) forms a bottom electrode of the MRAM device.

2. The method (10) according to claim 1, wherein:
the embedded layer (13) comprises a titanium layer, titanium nitride layer, tantalum layer, tantalum nitride layer, and/or tungsten layer.

3. The method (10) according to claim 1 or 2, wherein:
the MRAM stack (14) comprises a Magnetic Tunnel Junction, MTJ, stack, which includes two magnetic layers that sandwich a tunnel barrier, and
the MTJ stack (14) is fabricated directly on the embedded layer (13).

4. Method (10) according to one of the claims 1 to 3, wherein:
fabricating the MRAM stack (14) on the embedded layer (13) is performed in a single mask flow.

5. Method (10) according to one of the claims 1 to 4, further comprising:
pre-cleaning the recess (12), before depositing the embedded layer (13) into the recess.

6. Method (10) according to claim 5, wherein:
the pre-cleaning and the depositing of the embedded layer (13) are performed in-situ without an air break in between.

7. Method (10) according to claim 5 or 6, wherein:
the pre-cleaning comprises argon sputtering of the recess (12).

8. Method (10) according to one of the claims 1 to 7, wherein:
the recess (12) is formed by dry etching or wet etching, in particular by cyclic dry or wet etching.

9. Method (10) according to one of the claims 1 to 8, wherein:
the recess (12) has a depth of 20-30 nm into the top part of the copper plug.

10. Method (10) according to one of the claims 1 to 9, further comprising:
smoothing the surface of the embedded layer (13), before fabricating the MRAM stack (14) on the embedded layer (13).

11. Method (10) according to one of the claims 1 to 10, further comprising:
smoothing the surface of the copper plug (11), before forming the recess (12) in the top part of the copper plug (11).

12. Method according to one of the claims 1 to 11, further comprising:
fabricating a further copper plug (71) or a copper line on top of the MRAM device.

13. Method (10) according to claim 12, wherein:
the further copper plug (71) or the copper line is fabricated based on a Damascene process.

14. Integrated device (100) fabricated by using the method (10) according to any one of the claims 1 to 13.

15. Integrated device (100) including a Magnetoresistive Random Access Memory, MRAM, device integrated with a copper-based interconnect structure, the integrated device (100) comprising:
a copper plug (11) of the interconnect structure,
an embedded layer (13) formed in a recess (12) in a top part of the copper plug (11), and
an MRAM stack (14) arranged on the embedded layer (13),
wherein the MRAM device is formed by the MRAM stack (14) and the copper plug (11), the copper plug (11) forming a bottom electrode of the MRAM device.
